# EUROPEAN PATENT APPLICATION

(11) **EP 4 319 497 A1**
(43) Date of publication of application: **07.02.2024**
(21) Application number: 22794532.6
(22) Date of filing: 06.04.2022
(51) Int. Cl.: H05K 1/02, H05K 1/18

(54) **CIRCUIT BOARD ASSEMBLY AND ELECTRONIC DEVICE**

(30) Priority: 27.04.2021 CN 202110457497
(71) Applicant: Huawei Technologies Co., Ltd., Shenzhen, Guangdong 518129 (CN)
(72) Inventor: WU, Yulong, Shenzhen, Guangdong 518129 (CN); LI, Weiqiang, Shenzhen, Guangdong 518129 (CN)
(74) Representative: Körber, Martin Hans
(86) International application number: PCT/CN2022/085354
(87) International publication number: WO 2022/228061

(57) **Abstract**

This application discloses a circuit board assembly and an electronic device. The circuit board assembly is applied to the electronic device, and the circuit board assembly includes a circuit board carrying a large-sized chip and a substrate. The substrate is disposed on a side that is of the circuit board and that is opposite to the chip, and is connected to the circuit board. In this application, a deformation manner of the circuit board assembly is designed, to effectively reduce an impact of a stress generated by deformation of the substrate on self-deformation of the circuit board, and improve a long-term temperature cycle fatigue life of a solder joint between the chip and the circuit board.

## Description

This application claims priority to Chinese Patent Application No. 202110457497.X, filed with the China National Intellectual Property Administration on April 27, 2021 and entitled "CIRCUIT BOARD ASSEMBLY AND ELECTRONIC DEVICE", which is incorporated herein by reference in its entirety.

### TECHNICAL FIELD

This application relates to the field of electronic product technologies, and in particular, to a circuit board assembly and an electronic device.

### BACKGROUND

A substrate is disposed on a side that is of a circuit board carrying a large-sized chip and that is opposite to the chip, to improve mechanical strength of the circuit board, thereby enhancing protection and fastening effectsfor the chip. However, because a coefficient of thermal expansion of the substrate is different from that of the circuit board, when temperature at a structure such as the substrate or the circuit board changes relative to normal temperature, a deformation amount of the substrate is different from that of the circuit board, so that the circuit board generates non-self-deformation under an impact of deformation of the substrate. Therefore, a solder joint between the circuit board and the chip is subject to an extra structural deformation stress. This reduces a temperature cycle fatigue life of the solder joint and shortens a service life of the circuit board assembly.

### SUMMARY

This application discloses a circuit board assembly and an electronic device. The circuit board assembly is applied to the electronic device, and the electronic device has a relatively long service life. The circuit board assembly includes a circuit board carrying a large-sized chip and a substrate. The substrate is disposed on a side that is of the circuit board and that is opposite to the chip, and is connected to the circuit board. In this application, a deformation manner of the circuit board assembly is designed, to effectively reduce an impact of a force generated by deformation of the substrate on self-deformation of the circuit board, and improve a long-term temperature cycle fatigue life of a solder joint between the chip and the circuit board.

According to a first aspect, this application provides a circuit board assembly, including a circuit board and a substrate fastened to a side of the circuit board, where the circuit board has a first coefficient of thermal expansion, the substrate has a second coefficient of thermal expansion, and a difference between the second coefficient of thermal expansion and the first coefficient of thermal expansion is less than or equal to 30% of the first coefficient of thermal expansion.

In this application, a coefficient of thermal expansion of the substrate is close to that of the circuit board, so that when temperature at a structure such as the circuit board or the substrate changes relative to normal temperature, a deformation amount of the substrate is close to that of the circuit board. This prevents the circuit board from generating non-self-deformation under an impact of a substrate deformation force, and maintains deformation of the circuit board in a bare board state. In addition, a solder joint is not subject to a downward structural deformation stress, and a temperature cycle fatigue life of the solder joint is increased.

For example, the circuit board generally adopts resin to implement an insulation function. A coefficient of thermal expansion of the resin is relatively high. That is, a coefficient of thermal expansion of the circuit board is relatively high. In a traditional scheme, to ensure a protective effect of the substrate on the circuit board, the substrate generally adopts a material with relatively high mechanical strength such as metal and ceramic (for example, stainless steel, aluminum alloy, or the like). That is, the coefficient of thermal expansion of the substrate is relatively low. It may be understood that a coefficient of thermal expansion of a material with high mechanical strength is generally relatively low. When temperature at the circuit board and the substrate changes relative to normal temperature, a deformation amount of the circuit board with a higher coefficient of thermal expansion is greater than a deformation amount of the substrate with a lower coefficient of thermal expansion, resulting in a deformation amount mismatch between the substrate and the circuit board due to a coefficient of thermal expansion mismatch.

In this implementation, the coefficient of thermal expansion of the substrate is close to that of the circuit board. Although part of mechanical strength is sacrificed and a protection effect of the substrate is reduced, the deformation amount mismatch caused by the coefficient of thermal expansion mismatch between the substrate and the circuit board is reduced. Compared with the prior art, this embodiment reduces a substrate deformation force generated by deformation of the substrate on the circuit board, further reduces non-self-deformation generated by the circuit board, and eliminates or reduces a downward structural deformation stress on the solder joint, thereby improving a temperature cycle fatigue life of the solder joint, and increasing a service life of the circuit board assembly.

In a possible implementation, the substrate includes a first backplane and a second backplane, the second backplane is located on a side that is of the first backplane and that is opposite to the circuit board, a coefficient of thermal expansion of the first backplane is less than a coefficient of thermal expansion of the second backplane, and at least one of the first backplane and the second backplane is connected to the circuit board through fastening.

In this implementation, the coefficient of thermal expansion of the first backplane is less than the coefficient of thermal expansion of the second backplane, so that a thermal deformation amount of the first backplane is less than a thermal deformation amount of the second backplane. The substrate protrudes towards a side at which the second backplane with a large deformation amount is located. That is, two ends of the substrate are tilted upward, to match a deformation manner of the circuit board. Therefore, when temperature at a structure such as the circuit board or the substrate changes relative to normal temperature, a protrusion direction of the substrate is the same as a protrusion direction of the circuit board. This prevents the circuit board from generating non-self-deformation under an impact of a substrate deformation force, and maintains deformation of the circuit board in a bare board state. In addition, a solder joint is not subject to a downward structural deformation stress, and a temperature cycle fatigue life of the solder joint and a service life of the circuit board assembly are increased.

In this implementation, the coefficient of thermal expansion of the substrate may be close to the coefficient of thermal expansion of the circuit board. To be specific, a difference between the second coefficient of thermal expansion and the first coefficient of thermal expansion may be greater than 30% of the first coefficient of thermal expansion, to further reduce an impact of a substrate deformation force. The coefficient of thermal expansion of the substrate is a total coefficient of thermal expansion of a fastening structure formed by the first backplane and the second backplane.

In a possible implementation, the circuit board assembly further includes an intermediate buffer, two opposite sides of the intermediate buffer are respectively connected to the circuit board and the substrate through fastening, and the intermediate buffer can generate elastic deformation under an external force.

In this implementation, the intermediate buffer can deform by force. Deformation performance of the intermediate buffer may be utilized to reduce a connection effect between the circuit board and the substrate, eliminate a difference between deformation amounts of the circuit board and the substrate, prevent deformation of the circuit board from being affected by a substrate deformation force, and maintain deformation of the circuit board in a bare board state, so as to increase a temperature cycle fatigue life of a solder joint.

In a possible implementation, the circuit board assembly further includes:
a fastener, where the circuit board and the substrate are disposed in a stacked manner and a gap is formed between the circuit board and the substrate, the fastener is disposed at two ends of the circuit board, the fastener is inserted into the circuit board and is connected to the substrate through fastening, and a relative position of the circuit board and the substrate changes when the circuit board assembly is heated;
a first buffer, where the first buffer is located on a side that is of the circuit board and that is opposite to the substrate and is in contact with the circuit board, the fastener is inserted into the first buffer, and the first buffer deforms when the circuit board assembly is heated; and/or
a second buffer, where the second buffer is located between the circuit board and the substrate and is in contact with the circuit board and the substrate, the fastener is inserted into the second buffer, and the second buffer deforms when the circuit board assembly is heated.

In this implementation, when the circuit board assembly is heated, a relative position of the circuit board and the substrate changes and the first buffer deforms, to reduce a connection effect between the fastener and the circuit board, increase deformation space of the circuit board in a horizontal direction, and prevent deformation of the circuit board from being limited by the fastener. The second buffer deforms, to reduce a connection effect between the circuit board and the substrate, increase deformation space of the circuit board and the substrate in a horizontal direction, and prevent deformation of the circuit board from being affected by a substrate deformation force.

The first buffer and the second buffer may reduce a connection effect of the fastener on the circuit board and the substrate, and increase deformation space of the circuit board and the substrate in a horizontal direction while ensuring a fastening effect of the fastener. This prevents the circuit board from generating non-self-deformation, maintains deformation of the circuit board in a bare board state. In addition, this further prevents a solder joint from being subject to a structural deformation stress, and increases a temperature cycle fatigue life of the solder joint and a service life of the circuit board assembly.

For example, the buffer may also be disposed on an upper side or a lower side of the circuit board, to reduce a volume of the circuit board and a related assembly of the circuit board, so that a structure of the circuit board assembly is more compact. This is not limited in this application.

In a possible implementation, the circuit board assembly further includes a holder, the holder is located on a side that is of the circuit board and that is opposite to the substrate, two ends of the holder are connected to two ends of the circuit board through fastening, a gap is formed between a middle part of the holder and a middle part of the circuit board, and a coefficient of thermal expansion of the holder is less than a coefficient of thermal expansion of the circuit board.

In this implementation, when temperature at a structure such as the circuit board, the substrate, or the holder changes relative to normal temperature, a deformation amount of the holder is less than a deformation amount of the circuit board, so that an upward force can be applied to the two ends of the circuit board to offset an oblique downward substrate deformation force generated by deformation of the substrate on the circuit board, prevent the circuit board from generating non-self-deformation, and maintain deformation of the circuit board in a bare board state. In addition, this prevents a solder joint from being subject to a downward structural deformation stress, and increases a temperature cycle fatigue life of the solder joint and a service life of the circuit board assembly.

In a possible implementation, the holder includes an upper holder and a lower holder that are disposed in a stacked manner and connected through fastening, the upper holder is located on a side that is of the lower holder and that is opposite to the circuit board, two ends of at least one of the upper holder and the lower holder are connected to the circuit board through fastening, a gap is formed between a middle part of the lower holder and a middle part of the circuit board, and a coefficient of thermal expansion of the upper holder is less than a coefficient of thermal expansion of the lower holder.

In this implementation, when temperature at a structure such as the circuit board, the substrate, or the holder changes relative to normal temperature, the holder applies an upward force to the two ends of the circuit board, to further offset an oblique downward substrate deformation force generated by deformation of the substrate on the circuit board, and maintain deformation of the circuit board in a bare board state. In addition, a solder joint is not subject to a downward structural deformation stress, and a temperature cycle fatigue life of the solder joint is increased.

According to a second aspect, this application further provides a circuit board assembly, including a circuit board and a substrate connected to the circuit board through fastening, where the substrate includes a first backplane and a second backplane, the second backplane is located on a side that is of the first backplane and that is opposite to the circuit board, a coefficient of thermal expansion of the first backplane is less than a coefficient of thermal expansion of the second backplane, and at least one of the first backplane and the second backplane is connected to the circuit board through fastening.

In this implementation, an offset effect of deformation and match of the substrate on a substrate deformation force is used, to maintain deformation of the circuit board in a bare board state, and improve a temperature cycle fatigue life of a solder joint. For example, the first backplane may be a pre-galvanized steel sheet, and the second backplane may be an aluminum alloy steel sheet. In some other implementations, the first backplane and the second backplane may also adopt other materials, provided that the coefficient of thermal expansion of the first backplane may be less than the coefficient of thermal expansion of the second backplane. This is not limited in this application.

In some other implementations, the substrate may also adopt a structure of more than two layers, for example, three layers. This is not limited in this application, provided that when temperature at the substrate changes relative to normal temperature, a coefficient of thermal expansion of a multi-layer structure increases as a distance between the multi-layer structure and the circuit board increases, and a protrusion direction of the substrate is the same as a protrusion direction of the circuit board.

In a possible implementation, the circuit board assembly further includes an intermediate buffer, two opposite sides of the intermediate buffer are respectively connected to the circuit board and the substrate through fastening, and the intermediate buffer can generate elastic deformation under an external force.

In a possible implementation, the circuit board assembly further includes:
a fastener, where the circuit board and the substrate are disposed in a stacked manner and a gap is formed between the circuit board and the substrate, the fastener is disposed at two ends of the circuit board, is inserted into the circuit board and is connected to the substrate through fastening, and a relative position of the circuit board and the substrate changes when the circuit board assembly is heated;
a first buffer, where the first buffer is located on a side that is of the circuit board and that is opposite to the substrate and is in contact with the circuit board, the fastener is inserted into the first buffer, and the first buffer deforms when the circuit board assembly is heated; and/or
a second buffer, where the second buffer is located between the circuit board and the substrate and is in contact with the circuit board and the substrate, the fastener is inserted into the second buffer, and the second buffer deforms when the circuit board assembly is heated.

In a possible implementation, the circuit board assembly further includes a holder, the holder is located on a side that is of the circuit board and that is opposite to the substrate, two ends of the holder are connected to two ends of the circuit board through fastening, a gap is formed between a middle part of the holder and a middle part of the circuit board, and a coefficient of thermal expansion of the holder is less than a coefficient of thermal expansion of the circuit board.

In a possible implementation, the holder includes an upper holder and a lower holder that are disposed in a stacked manner and connected through fastening, the upper holder is located on a side that is of the lower holder and that is opposite to the circuit board, two ends of at least one of the upper holder and the lower holder are connected to the circuit board through fastening, a gap is formed between a middle part of the lower holder and a middle part of the circuit board, and a coefficient of thermal expansion of the upper holder is less than a coefficient of thermal expansion of the lower holder.

According to a third aspect, this application further provides a circuit board assembly, including a circuit board, a substrate, and a fastener, where the circuit board and the substrate are disposed in a stacked manner and a gap is formed between the circuit board and the substrate, the fastener is disposed at two ends of the circuit board, the fastener is inserted into the circuit board and is connected to the substrate through fastening, and a relative position of the circuit board and the substrate changes when the circuit board assembly is heated;

The circuit board assembly further includes:
a first buffer, where the first buffer is located on a side that is of the circuit board and that is opposite to the substrate and is in contact with the circuit board, the fastener is inserted into the first buffer, and the first buffer deforms when the circuit board assembly is heated; and/or
a second buffer, where the second buffer is located between the circuit board and the substrate and is in contact with the circuit board and the substrate, the fastener is inserted into the second buffer, and the second buffer deforms when the circuit board assembly is heated.

In a possible implementation, the first buffer adopts foam, rubber, or a spring, and/or the second buffer adopts foam, rubber, PTFE, or a spring.

In this implementation, an offset effect of a buffer on a substrate deformation force is used, to maintain deformation of the circuit board in a bare board state, and improve a temperature cycle fatigue life of a solder joint. For example, the buffer may adopt an elastic material of rubber, foam, PTFE (poly tetra fluoroethylene, poly tetra fluoroethylene), or the like, or may adopt a structure that may elastically deform by force, such as a spring. The buffer may adopt a bionic design structure to better match a shape of the circuit board after deformation, and increase a fastening effect of the fastener on the circuit board and substrate.

In a possible implementation, the fastener includes a limiting part and a plug connector that are connected through fastening, the limiting part protrudes outwards relative to a peripheral side of the plug connector, and the first buffer is located between the limiting part and the circuit board and is in contact with the limiting part and the circuit board.

In a possible implementation, the circuit board assembly further includes a holder, the holder is located on a side that is of the circuit board and that is opposite to the substrate, two ends of the holder are connected to two ends of the circuit board through fastening, a gap is formed between a middle part of the holder and a middle part of the circuit board, and a coefficient of thermal expansion of the holder is less than a coefficient of thermal expansion of the circuit board.

In a possible implementation, the holder includes an upper holder and a lower holder that are disposed in a stacked manner and connected through fastening, the upper holder is located on a side that is of the lower holder and that is opposite to the circuit board, two ends of at least one of the upper holder and the lower holder are connected to the circuit board through fastening, a gap is formed between a middle part of the lower holder and a middle part of the circuit board, and a coefficient of thermal expansion of the upper holder is less than a coefficient of thermal expansion of the lower holder.

For example, the upper holder may be a pre-galvanized steel sheet, and the lower holder may be an aluminum alloy steel sheet. In some other implementations, the upper holder and the lower holder may also adopt other materials, provided that the coefficient of thermal expansion of the upper holder may be less than the coefficient of thermal expansion of the lower holder. This is not limited in this application.

In this implementation, the holder may adopt a double-layer structure, that is, includes the upper holder and the lower holder that are disposed in a stacked manner. In some other implementations, the holder may also adopt a structure of more than two layers, for example, three layers. This is not limited in this application, provided that when temperature at the holder changes relative to normal temperature, a coefficient of thermal expansion of a multi-layer structure decreases as a distance between the multi-layer structure and the circuit board increases, so that a protrusion direction of the holder is the same as a protrusion direction of the circuit board.

According to a fourth aspect, this application further provides a circuit board assembly, including a circuit board, a substrate, and a holder, where the substrate is connected to the circuit board through fastening, the holder is located on a side that is of the circuit board and that is opposite to the substrate, two ends of the holder are connected to two ends of the circuit board through fastening, a gap is formed between a middle part of the holder and a middle part of the circuit board, and a coefficient of thermal expansion of the holder is less than a coefficient of thermal expansion of the circuit board.

In this implementation, an offset effect of the holder on a substrate deformation force is used, to maintain deformation of the circuit board in a bare board state, and improve a temperature cycle fatigue life of a solder joint.

In a possible implementation, the holder includes an upper holder and a lower holder that are disposed in a stacked manner and connected through fastening, the upper holder is located on a side that is of the lower holder and that is opposite to the circuit board, two ends of at least one of the upper holder and the lower holder are connected to the circuit board through fastening, a gap is formed between a middle part of the lower holder and a middle part of the circuit board, and a coefficient of thermal expansion of the upper holder is less than a coefficient of thermal expansion of the lower holder.

According to a fifth aspect, this application provides an electronic device, including the foregoing circuit board assembly, where the circuit board assembly includes a chip, and the chip is fastened to a side that is of the circuit board and that is opposite to the substrate. The electronic device has a relatively long service life.

### BRIEF DESCRIPTION OF DRAWINGS

FIG. 1 is a schematic diagram of a partial structure of an electronic device in some embodiments according to this application;
FIG. 2A is a schematic diagram of a structure of the circuit board assembly shown in FIG. 1 in some embodiments;
FIG. 2B is a schematic diagram of a structure of the circuit board assembly shown in FIG. 1 in some other embodiments;
FIG. 3A is a schematic diagram of deformation of a circuit board assembly in a bare board state;
FIG. 3B is a schematic diagram of deformation of a circuit board assembly adopting a conventional structure;
FIG. 4 is a schematic diagram of deformation of the circuit board assembly shown in FIG. 2A in some embodiments according to this application;
FIG. 5 is a schematic diagram of deformation of the circuit board assembly shown in FIG. 2A in some other embodiments according to this application;
FIG. 6 is a schematic diagram of deformation of the substrate shown in FIG. 5;
FIG. 7 is a schematic diagram of a structure of the circuit board assembly shown in FIG. 2A in still some other embodiments according to this application;
FIG. 8 is a schematic diagram of deformation of the circuit board assembly shown in FIG. 7;
FIG. 9 is a schematic diagram of a structure of the circuit board assembly shown in FIG. 2A in yet some other embodiments according to this application;
FIG. 10 is a schematic diagram of deformation of the circuit board assembly shown in FIG. 9; and
FIG. 11 is a schematic diagram of deformation of the circuit board assembly shown in FIG. 2A in still yet some other embodiments according to this application.

### DESCRIPTION OF EMBODIMENTS

The following describes embodiments of this application with reference to the accompanying drawings in embodiments of this application. A term "and/or" in this specification describes only an association relationship between associated objects and indicates that there may be three relationships. For example, A and/or B may represent the following three cases: Only A exists, both A and B exist, and only B exists. In addition, in the descriptions in embodiments of this application, "a plurality of means two or more unless otherwise specified. "More than" includes a number, for example, more than two includes two.

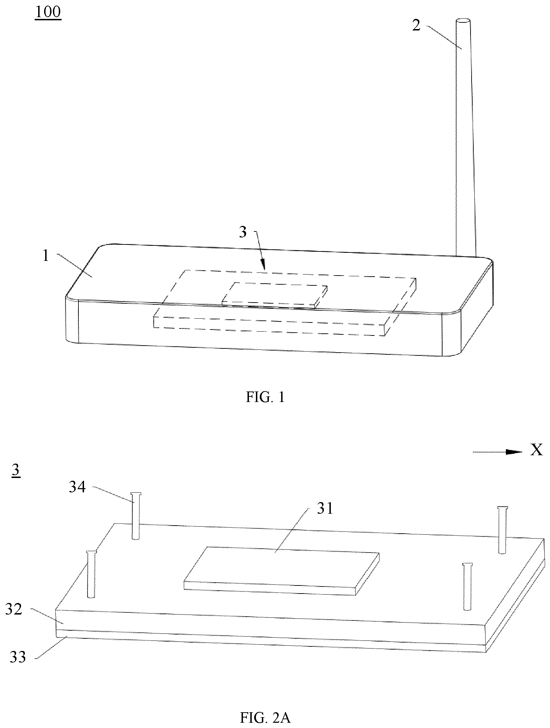

FIG. 1 is a schematic diagram of a partial structure of an electronic device 100 in some embodiments according to this application. The electronic device 100 may be an electronic product (for example, a server, a router, a mobile phone, a notebook computer, a television, a smart home device, a vehicular device, or the like) applied to fields such as signal transmission, access, and calculation, wireless communication, and the like.

For example, the electronic device 100 may include a hollow housing 1 and an antenna 2. The antenna 2 may be configured to receive and transmit a signal, and implement wireless transmission of the signal by using an electromagnetic wave. The antenna 2 may be fastened to an outer side of the housing 1, or may be installed inside the housing 1. In some other embodiments, the electronic device 100 may alternatively not include the antenna 2, but adopt another signal transmission manner such as an optical fiber, a cable, or the like. This is not limited in this application.

For example, the housing 1 may include an inner cavity of the housing that is configured to accommodate an internal structure of the electronic device 100. The electronic device 100 may further include a circuit board assembly 3 installed in the inner cavity of the housing.

For example, the electronic device 100 may further include a heat sink (not shown in the figure) connected to the circuit board assembly 3 through fastening. The heat sink may be a plate-shaped, sheet-shaped, or multi-sheet-shaped structure made of aluminum alloy, brass, or bronze, and is configured to dissipate heat of the circuit board assembly 3, to reduce temperature of the circuit board assembly 3, ensure running stability of the circuit board assembly 3, and increase a service life of the circuit board assembly 3.

FIG. 2A is a schematic diagram of a structure of the circuit board assembly 3 shown in FIG. 1 in some embodiments. For example, the circuit board assembly 3 may include a chip 31, a circuit board 32, a substrate 33, and a fastener 34.

The circuit board 32 is connected to the substrate 33 through fastening, and a lower surface of the circuit board 32 may be attached to an upper surface of the substrate 33. It may be understood that, in this application, two parts may be connected through fastening by using a connector. The two parts are connected through fastening means that a position relationship between the two parts remains unchanged, but a position relationship change caused by deformation of the connector between the two parts is allowed. In addition, orientation terms such as "on", "below", "inside", and "outside" in this application are descriptions with reference to orientations in the accompanying drawings, and do not indicate or imply that a described apparatus or element must have a particular orientation, be constructed and operated in a particular orientation, and therefore cannot be understood as a limitation on this application.

For example, the circuit board 32 and the substrate 33 may be connected through fastening by using the fastener 34, and the fastener 34 is disposed at two ends of the circuit board 32. The fastener 34 is inserted into the circuit board 32 and is connected to the substrate 33 through fastening. The circuit board 32 and the substrate 33 are disposed in a stacked manner and a gap is formed between the circuit board 32 and the substrate 33. A relative position of the circuit board 32 and the substrate 33 changes when the circuit board assembly 3 is heated. The fastener 34 may be a fastening piece such as a screw, a rivet, or the like. In some other embodiments, the circuit board 32 may also be connected to the substrate 33 through fastening in a manner of adhesive bonding, welding, or the like.

For example, when the fastener 34 is a screw, the substrate 33 may include a screw hole (not shown in the figure) whose opening faces the circuit board 32, and an inner thread fitting a thread on a periphery side of the screw is disposed on an inner wall of the screw hole. The screw may be extended into the screw hole, and is fitted with and fastened to the screw hole, to be connected to the substrate 33 through fastening.

For example, the chip 31 is fastened to a side that is of the circuit board 32 and that is opposite to the substrate 33, and is electrically connected to the side. The chip 31 may be configured to transmit a signal, or may process a signal.

For example, the chip 31 may be a large-sized ASIC (application specific integrated circuit, application-specific integrated circuit) chip, can be specifically designed and manufactured according to a product requirement to implement enhancement of a specific function, and has a relatively high processing speed and low energy consumption. Alternatively, the chip 31 may be a general-purpose chip, such as a CPU (central processing unit, central processing unit), a GPU (graphics processing unit, graphics processing unit), or a semi-customized chip such as an FPGA (field programmable gate array, field programmable gate array). This is not limited in this embodiment of this application.

For example, the chip 31 may be connected through fastening to and electrically connected to the circuit board 32 by using a solder joint. For example, the chip 31 may be connected to the circuit board 32 in a BGA (ball grid array package, ball grid array package) manner, or may be connected to the circuit board 32 in an SMT (surface mounted technology, surface-mounted technology) manner, or the like. In some other embodiments, the chip 31 may also be connected through fastening to and electrically connected to the circuit board 32 by using a conductive adhesive or the like. A connection manner of the chip 31 and the circuit board 32 is not limited in this application.

In this application, the electronic device 100 adopts the large-sized ASIC chip, to meet a high-power use requirement, and at the same time generate more heat, so that the circuit board 32 and the substrate 33 are heated and generate thermal strain.

For example, in this application, an example in which the chip 31 is connected to the circuit board 32 in the BGA manner is used for description. The circuit board assembly 3 may further include a plurality of solder joints (not shown in the figure). The solder joints are disposed between the chip 31 and the circuit board 32, and are connected to the chip 31 and the circuit board 32 through fastening, to implement a fastened connection and an electrical connection between the chip 31 and the circuit board 32.

In this application, a horizontal direction X is a direction parallel to a plane on which an upper surface of the circuit board 32 that not deforms is located. For example, the horizontal direction X may be any direction parallel to the plane on which the upper surface of the circuit board 32 that not deforms is located. This is not limited in this embodiment of this application.

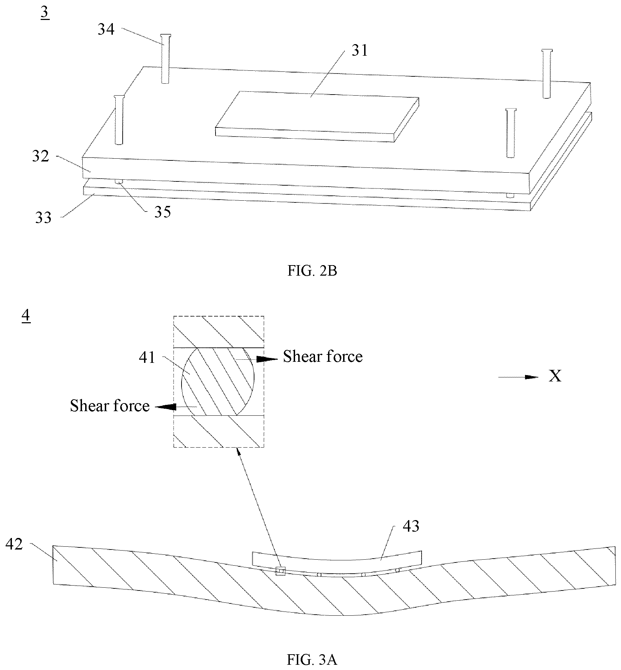

FIG. 2B is a schematic diagram of a structure of the circuit board assembly 3 shown in FIG. 1 in some other embodiments. For example, the circuit board assembly 3 may also include a support member 35, and the support member 35 may be fastened to a side that is of the substrate 33 and that faces the circuit board 32, and protrudes relative to the upper surface of the substrate 33. In this case, a gap exists between the lower surface of the circuit board 32 and the upper surface of the substrate 33, and plenty of space is reserved for deformation of the circuit board 32. The support member 35 may be in contact with or abut against a lower surface that is of the circuit board 32 and that is opposite to the chip 31, and the fastener 34 passes through the circuit board 32 and is connected to the support member 35 through fastening.

For example, when the fastener 34 is a screw, the support member 35 may be a nut matching the screw, and the screw passes through the circuit board 32 and locks with the nut. The nut may be fastened on a side that is of the substrate 33 and that faces the circuit board 32, and is in contact with or abuts against the lower surface of the circuit board 32.

FIG. 3A is a schematic diagram of deformation of a circuit board assembly 4 in a bare board state, where a partial zoom-in diagram in FIG. 3A shows a schematic diagram of a force exerted on a solder joint 41.

In this application, the circuit board assembly 4 in the bare board state includes a circuit board 42, a chip 43 welded to the circuit board 42, and a solder joint 41 between the circuit board 42 and the chip 43, and no substrate is disposed on a side that is of the circuit board 42 and that is opposite to the chip 43 for the circuit board assembly 4 in the bare board state.

For example, the circuit board 42 is generally configured to carry electronic elements and implement electrical connection between the electronic elements. When temperature at the circuit board assembly 4 in the bare board state changes relative to normal temperature, the circuit board assembly 4 deforms. Specifically, when temperature at the chip 43 and the circuit board 42 increases relative to normal temperature, that is, when the chip 43 and the circuit board 42 are at high temperature, the circuit board 42 and the chip 43 deform with the middle being concave and two ends being tilted, and present a "smile-face" shape. When temperature at the chip 43 and the circuit board 42 decreases relative to normal temperature, that is, when the chip 43 and the circuit board 42 are at low temperature, the circuit board 42 and the chip 43 protrude in the middle, and present a "cry-face" shape. In addition, a deformation amount of the circuit board 42 is greater than a deformation amount of the chip 43. An upper end and a lower end of the solder joint 41 are respectively connected to the chip 43 and the circuit board 42 through fastening. A deformation amount mismatch between the chip 43 and the circuit board 42 causes the upper end and the lower end of the solder joint 41 to be respectively subject to shear forces in the horizontal direction X and in opposite directions.

In addition, when temperature at the chip 43 and the circuit board 42 returns to normal temperature, the circuit board 42 recovers from a deformed state to a state in which no deformation occurs. When the temperature at the chip 43 and the circuit board 42 changes relative to normal temperature, the circuit board 42 deforms again, and a shear force is generated on the solder joint 41, which is performed cyclically, so that temperature cycle fatigue occurs on the solder joint 41.

In this application, the temperature at the circuit board assembly 4 within a range of 20°C to 30°C may be considered as normal temperature, temperature within a range of the normal temperature to 200°C may be considered as high temperature, and temperature within a range of -100°C to the normal temperature may be considered as low temperature.

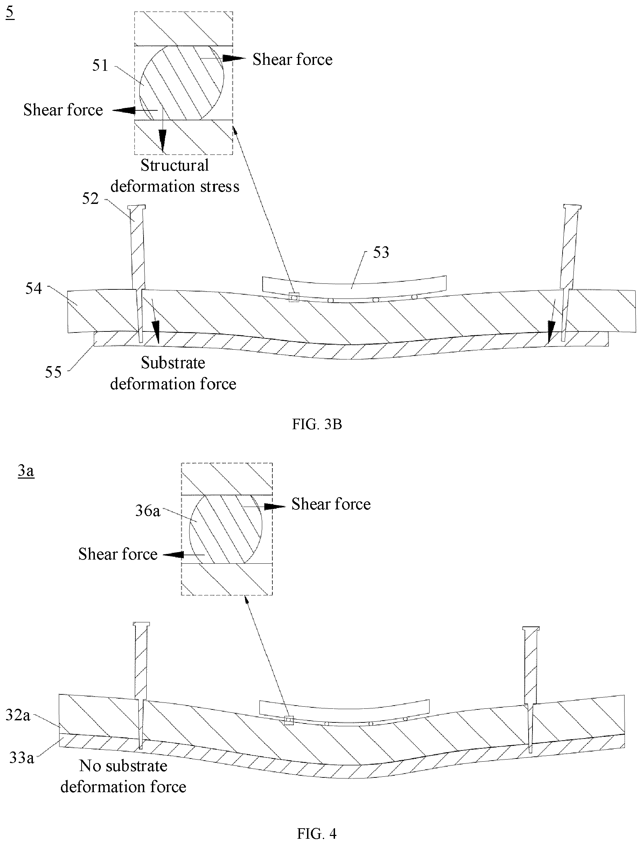

FIG. 3B is a schematic diagram of deformation of a circuit board assembly 5 adopting a conventional structure, where a partial zoom-in diagram in FIG. 3B shows a schematic diagram of a force exerted on a solder joint 51.

In this application, the circuit board assembly 5 adopting the conventional structure includes a chip 53, a circuit board 54, a substrate 55, a fastener 52, and the solder joint 51. The chip 53 is welded to the circuit board 54, and the solder joint is located between the circuit board 54 and the chip 53. The fastener 52 is disposed at two ends of the circuit board 54. The fastener 52 is inserted into the circuit board 54 and is connected to the substrate 55 through fastening.

Different from a deformation manner of a circuit board assembly 5 in a bare board state, when the two ends of the circuit board 54 are connected to the substrate 55 through fastening by using the fastener 52, the substrate 55 generates an oblique downward substrate deformation force on the circuit board 54 by using a connection effect of the fastener 52. This causes a change in a deformation manner of the circuit board 54 when heated, and generates non-self-deformation. Specifically, the two ends of the circuit board 54 are bent downward under a substrate deformation force, and present an "M" shape, so that the solder joint 51 is subject both to a shear force in the horizontal direction X and to a downward structural deformation stress. As a result, a probability that a crack occurs on the solder joint 51 is increased, and a temperature cycle fatigue life of the solder joint 51 is significantly reduced.

FIG. 4 is a schematic diagram of deformation of the circuit board assembly 3 shown in FIG. 2A in some embodiments according to this application. In a first embodiment, a circuit board 32a may have a first coefficient of thermal expansion (coefficient of thermal epansion, CTE), and a substrate 33a may have a second coefficient of thermal expansion. The second coefficient of thermal expansion may be close to the first coefficient of thermal expansion. To be specific, a difference between the second coefficient of thermal expansion and the first coefficient of thermal expansion is less than or equal to 30% of the first coefficient of thermal expansion. For example, the second coefficient of thermal expansion may be equal to the first coefficient of thermal expansion, and a difference between the second coefficient of thermal expansion and the first coefficient of thermal expansion may also be 1%, 5%, 15%, or the like, of the first coefficient of thermal expansion. This is not limited in this embodiment.

Refer to FIG. 3B and FIG. 4 together. In this application, a coefficient of thermal expansion of the substrate 33a is close to that of the circuit board 32a, so that when temperature at a structure such as the circuit board 32a or the substrate 33a changes relative to normal temperature, a deformation amount of the substrate 33a is close to that of the circuit board 32a. This prevents the circuit board 32a from generating non-self-deformation under an impact of a substrate deformation force, and maintains deformation of the circuit board 32a in a bare board state. In addition, a solder joint 36a is not subject to a downward structural deformation stress, and a temperature cycle fatigue life of the solder joint 36a is increased.

For example, the circuit board 32a generally adopts resin to implement an insulation function. A coefficient of thermal expansion of the resin is relatively high. That is, a coefficient of thermal expansion of the circuit board 32a is relatively high. In a traditional scheme, to ensure a protective effect of the substrate 33a on the circuit board 32a, the substrate 33a generally adopts a material with relatively high mechanical strength such as metal and ceramic (for example, stainless steel, aluminum alloy, or the like). That is, the coefficient of thermal expansion of the substrate 33a is relatively low. It may be understood that a coefficient of thermal expansion of a material with high mechanical strength is generally relatively low. When temperature at the circuit board 32a and the substrate 33a changes relative to normal temperature, a deformation amount of the circuit board 32a with a higher coefficient of thermal expansion is greater than a deformation amount of the substrate 33a with a lower coefficient of thermal expansion, resulting in a deformation amount mismatch between the substrate 33a and the circuit board 32a due to a coefficient of thermal expansion mismatch.

In this embodiment, the coefficient of thermal expansion of the substrate 33a is close to that of the circuit board 32a. Although part of mechanical strength is sacrificed and a protection effect of the substrate 33a is reduced, the deformation amount mismatch caused by the coefficient of thermal expansion mismatch between the substrate 33a and the circuit board 32a is reduced. Compared with the prior art, this embodiment reduces a substrate deformation force generated by deformation of the substrate 33a on the circuit board 32a, further reduces non-self-deformation generated by the circuit board 32a, and eliminates or reduces a downward structural deformation stress on the solder joint 36a, thereby improving a temperature cycle fatigue life of the solder joint 36a, and increasing a service life of the circuit board assembly 3a.

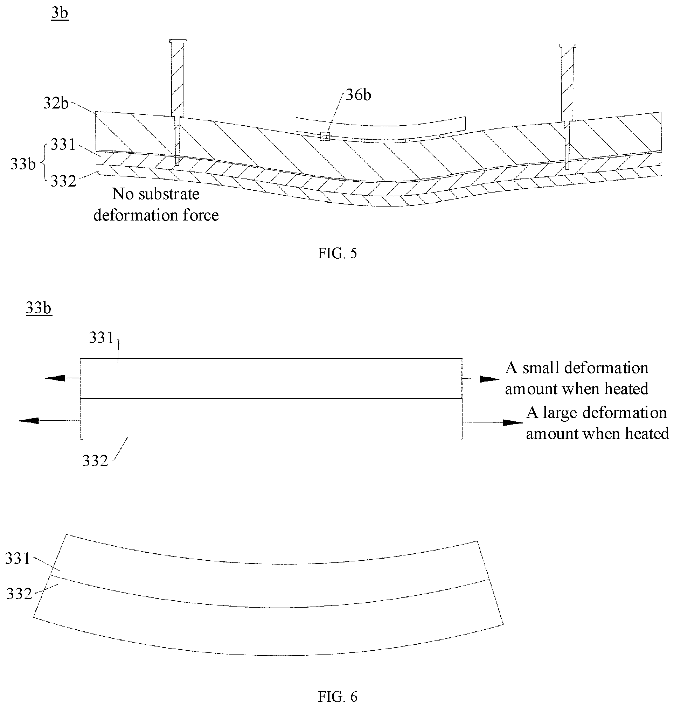

FIG. 5 is a schematic diagram of deformation of the circuit board assembly 3 shown in FIG. 2A in some other embodiments according to this application. In a second embodiment, most structures of a circuit board assembly 3b are the same as those in the first embodiment, and are not described herein again.

For example, a substrate 33b may include a first backplane 331 and a second backplane 332 that are disposed in a stacked manner and connected through fastening. The second backplane 332 is located on a side that is of the first backplane 331 and that is opposite to a circuit board 32b. A coefficient of thermal expansion of the first backplane 331 may be less than a coefficient of thermal expansion of the second backplane 332. For example, the first backplane 331 may be a pre-galvanized steel sheet, and the second backplane 332 may be an aluminum alloy steel sheet. In some other embodiments, the first backplane 331 and the second backplane 332 may also adopt other materials, provided that the coefficient of thermal expansion of the first backplane 331 may be less than the coefficient of thermal expansion of the second backplane 332. This is not limited in this embodiment of this application.

FIG. 6 is a schematic diagram of deformation of the substrate 33b shown in FIG. 5. In this embodiment, the substrate 33b adopts a double-layer structure. To be specific, the substrate 33b includes the first backplane 331 and the second backplane 332 that are disposed in a stacked manner. The coefficient of thermal expansion of the first backplane 331 is less than the coefficient of thermal expansion of the second backplane 332, so that a thermal deformation amount of the first backplane 331 is less than a thermal deformation amount of the second backplane 332. The substrate 33b protrudes towards a side at which the second backplane 332 with a large deformation amount is located. That is, two ends of the substrate 33b are tilted upward, to match a deformation manner of the circuit board 32b. Therefore, in this embodiment, when temperature at a structure such as the circuit board 32b or the substrate 33b changes relative to normal temperature, a protrusion direction of the substrate 33b is the same as a protrusion direction of the circuit board 32b. This prevents the circuit board 32b from generating non-self-deformation under an impact of a substrate deformation force, and maintains deformation of the circuit board 32b in a bare board state. In addition, a solder joint 36b is not subject to a downward structural deformation stress, and a temperature cycle fatigue life of the solder joint 36b and a service life of the circuit board assembly 3b are increased.

In some other embodiments, the substrate 33b may also adopt a structure of more than two layers, for example, three layers. This is not limited in this embodiment of this application, provided that when temperature at the substrate 33b changes relative to normal temperature, a coefficient of thermal expansion of a multi-layer structure increases as a distance between the multi-layer structure and the circuit board 32b increases, and a protrusion direction of the substrate 33b is the same as a protrusion direction of the circuit board 32b.

For example, in the second embodiment, a coefficient of thermal expansion of the substrate 33b may be close to or may not be close to a coefficient of thermal expansion of the circuit board 32b. To be specific, a difference between the second coefficient of thermal expansion and the first coefficient of thermal expansion may be greater than 30% of the first coefficient of thermal expansion, to further reduce an impact of the substrate deformation force. In this embodiment, the coefficient of thermal expansion of the substrate 33b is a total coefficient of thermal expansion of a fastening structure formed by the first backplane 331 and the second backplane 332.

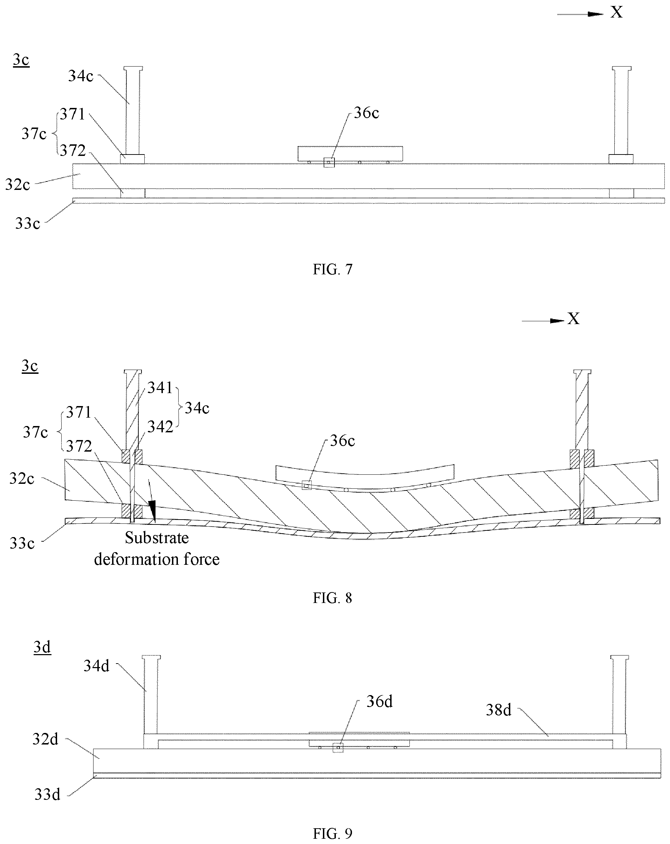

FIG. 7 is a schematic diagram of a structure of the circuit board assembly 3 shown in FIG. 2A in still some other embodiments according to this application.

In a third embodiment, a circuit board assembly 3c may include a buffer 37c (for example, a first buffer 371 and a second buffer 372) that is configured to reduce a connection effect of a fastener 34c on a circuit board 32c and a substrate 33c. The first buffer 371 and the second buffer 372 may be respectively disposed on a lower side and an upper side of the circuit board 32c.

For example, the first buffer 371 may be located on the upper side of the circuit board 32c, that is, located on a side that is of the circuit board 32c and that is opposite to the substrate 33c and that is in contact with the circuit board 32c, and the fastener 34c is inserted into the first buffer 371. The fastener 34c may include a limiting part 341 and a plug connector 341. The limiting part 341 protrudes outwards relative to a peripheral side of the plug connector 341. The first buffer 371 is located between the limiting part 341 and the circuit board 32c and is in contact with the limiting part 341 and the circuit board 32c.

For example, the second buffer 372 is located on the lower side of the circuit board 32c, that is, located between the circuit board 32c and the substrate 33c and is in contact with the circuit board 32c and the substrate 33c, and the fastener 34c is inserted into the second buffer 372.

FIG. 8 is a schematic diagram of deformation of the circuit board assembly 3c shown in FIG. 7.

In this embodiment, when the circuit board assembly 3c is heated, a relative position of the circuit board 32c and the substrate 33c changes, and the first buffer 371 deforms, to reduce a connection effect between the fastener 34c and the circuit board 32c, increase deformation space of the circuit board 32c in a horizontal direction X, and prevent deformation of the circuit board 32c from being limited by the fastener 34c. The second buffer 372 deforms to reduce a connection effect between the circuit board 32c and the substrate 33c, increase deformation space of the circuit board 32c and the substrate 33c in a horizontal direction X, and prevent deformation of the circuit board 32c from being affected by a substrate deformation force.

In this embodiment, the first buffer 371 and the second buffer 372 may reduce a connection effect of the fastener 34c on the circuit board 32c and the substrate 33c, and increase deformation space of the circuit board 32c and the substrate 33c in a horizontal direction X while ensuring a fastening effect of the fastener 34c. This prevents the circuit board 32c from generating non-self-deformation, maintains deformation of the circuit board 32c in a bare board state. In addition, this further prevents a solder joint 36c from being subject to a structural deformation stress, and increases a temperature cycle fatigue life of the solder joint 36c and a service life of the circuit board assembly 3c.

For example, the buffer 37c may also be disposed on an upper side or a lower side of the circuit board 32c, to reduce a volume of the circuit board 32c and a related assembly of the circuit board, so that a structure of the circuit board assembly 3c is more compact. This is not limited in this application.

For example, the circuit board assembly 3c may alternatively not be provided with the fastener 34c, and the circuit board 32c and the substrate 33c are connected through fastening by using an intermediate buffer (not shown in the figure). That is, the intermediate buffer may be provided between the circuit board 32c and the substrate 33c, and two sides of the intermediate buffer are respectively connected to the circuit board 32c and the substrate 33c through fastening. The intermediate buffer can deform by force. Deformation performance of the intermediate buffer may be utilized to reduce a connection effect between the circuit board 32c and the substrate 33c, eliminate a difference between deformation amounts of the circuit board 32c and the substrate 33c, prevent deformation of the circuit board 32c from being affected by a substrate deformation force, and maintain deformation of the circuit board 32c in a bare board state, to increase a temperature cycle fatigue life of the solder joint 36c.

For example, the buffer 37c may adopt an elastic material of rubber, foam, PTFE (poly tetra fluoroethylene, poly tetra fluoroethylene), or the like, or may adopt a structure that may elastically deform by force, such as a spring. The buffer 37c may adopt a bionic design structure to better match a shape of the circuit board 32c after deformation, and increase a fastening effect of the fastener 34c on the circuit board 32c and substrate 33c.

For example, in the third embodiment, the substrate 33c may adopt a single-layer structure, or may adopt a double-layer structure or a structure of more than two layers. Deformation and match of the buffer 37c and the substrate 33c is used, to maintain deformation of the circuit board 32c in a bare board state, and improve a temperature cycle fatigue life of the solder joint 36c. For a structure of and a specific manner of disposing a multi-layer substrate 33c, refer to the second embodiment, and details are not described herein again.

For example, in the third embodiment, a coefficient of thermal expansion of the substrate 33c may be close to a coefficient of thermal expansion of the circuit board 32c, to reduce a difference between deformation amounts of the substrate 33c and the circuit board 32c, and increase a temperature cycle fatigue life of the solder joint 36c. For a structure of and a specific manner of disposing the substrate 33c, refer to the first embodiment, and details are not described herein again. It may be understood that the coefficient of thermal expansion of the substrate 33c may also be not close to the coefficient of thermal expansion of the circuit board 32c. This is not limited in this embodiment.

FIG. 9 is a schematic diagram of a structure of the circuit board assembly 3 shown in FIG. 2A in yet some other embodiments according to this application. In a fourth embodiment, most structures of a circuit board assembly 3d are the same as those in the first embodiment, and are not described herein again.

For example, the circuit board assembly 3d may include a holder 38d. The holder 38d is located on a side that is of a circuit board 32d and that is opposite to a substrate 33d, and two ends of the holder 38d may be connected to two ends of the circuit board 32d through fastening by using a fastener 34d.

For example, a gap is formed between a middle part of the holder 38d and a middle part of the circuit board 32d. A coefficient of thermal expansion of the holder 38d may be less than a coefficient of thermal expansion of the circuit board 32d, so that when the holder 38d, the circuit board 32d, and the substrate 33d are heated, a deformation amount of the holder 38d is less than a deformation amount of the circuit board 32d.

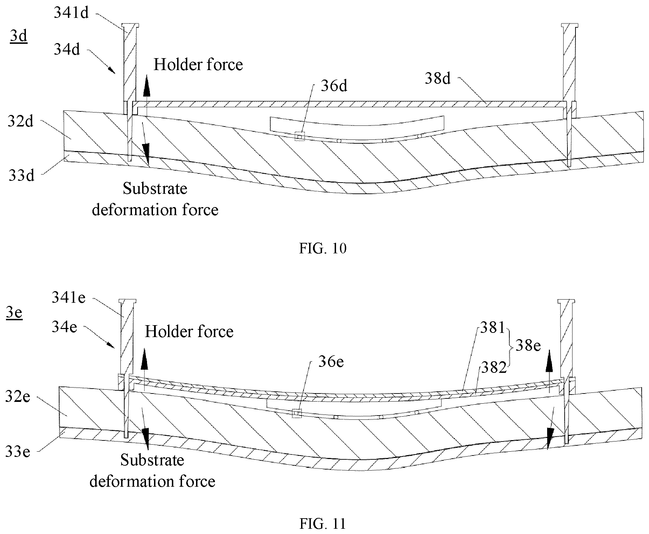

FIG. 10 is a schematic diagram of deformation of the circuit board assembly 3d shown in FIG. 9. When temperature at a structure such as the circuit board 32d, the substrate 33d, or the holder 38d changes relative to normal temperature, the deformation amount of the holder 38d is less than the deformation amount of the circuit board 32d, so that a force can be applied to the two ends of the circuit board 32d to offset a substrate deformation force generated by deformation of the substrate 33d on the circuit board 32d. This prevents the circuit board 32d from generating non-self-deformation, and maintains deformation of the circuit board 32d in a bare board state. In addition, this prevents a solder joint 36d from being subject to a downward structural deformation stress, and increases a temperature cycle fatigue life of the solder joint 36d and a service life of the circuit board assembly 3d.

FIG. 11 is a schematic diagram of deformation of the circuit board assembly 3 shown in FIG. 2A in still yet some other embodiments according to this application. In a fifth embodiment, most structures of a circuit board assembly 3e are the same as those in the fourth embodiment, and are not described herein again. For example, a holder 38e may include an upper holder 381 and a lower holder 382 that are disposed in a stacked manner and connected through fastening, and the upper holder 381 is located on a side that is of the lower holder 382 and that is opposite to a circuit board 32e. Two ends of at least one of the upper holder 381 and the lower holder 382 are connected to the circuit board 32e through fastening, and a gap is formed between a middle part of the lower holder 382 and a middle part of the circuit board 32e.

For example, a coefficient of thermal expansion of the upper holder 381 may be less than a coefficient of thermal expansion of the lower holder 382, so that a thermal deformation amount of the upper holder 381 is less than a thermal deformation amount of the lower holder 381. The holder 38e protrudes towards a side at which the lower holder 381 with a large deformation amount is located. That is, two ends of the holder 38e are tilted upward, to match a deformation manner of the circuit board 32e. Therefore, in this application, when temperature at a structure such as the circuit board 32e, the substrate 33e, or the holder 38e changes relative to normal temperature, the holder 38e applies an upward force to two ends of the circuit board 32e, to offset an oblique downward substrate deformation force generated by deformation of the substrate 33e on the circuit board 32e, and maintain deformation of the circuit board 32e in a bare board state. In addition, a solder joint 36e is not subject to a downward structural deformation stress, and a temperature cycle fatigue life of the solder joint 36e is increased.

For example, the upper holder 381 may be a pre-galvanized steel sheet, and the lower holder 382 may be an aluminum alloy steel sheet. In some other embodiments, the upper holder 381 and the lower holder 382 may also adopt other materials, provided that the coefficient of thermal expansion of the upper holder 381 may be less than the coefficient of thermal expansion of the lower holder 382. This is not limited in this embodiment of this application.

In this embodiment, the holder 38e may adopt a double-layer structure, that is, includes the upper holder 381 and the lower holder 382 that are disposed in a stacked manner. In some other embodiments, the holder 38e may also adopt a structure of more than two layers, for example, three layers. This is not limited in this embodiment of this application, provided that when temperature at the holder 3 8e changes relative to normal temperature, a coefficient of thermal expansion of a multi-layer structure decreases as a distance between the multi-layer structure and the circuit board 32e increases, so that a protrusion direction of the holder 38e is the same as a protrusion direction of the circuit board 32e.

For example, in the fifth embodiment, a total deformation amount of a single-layer or multi-layer holder 38e may be consistent with a deformation amount of the circuit board 32e. Under a premise of offsetting the substrate deformation force, an additional deformation force is prevented from being applied to the circuit board 32e, deformation of the circuit board 32e in a bare board state is maintained, and a temperature cycle fatigue life of the solder joint 36e is further increased.

Refer to FIG. 10 and FIG. 11 together. For example, in the fourth embodiment and/or the fifth embodiment, a circuit board assembly (3d, 3e) may not include a fastener (34d, 34e), two ends of a holder (38d, 38e) may also be connected to two ends of a circuit board (32d, 32e) through fastening in a manner of welding, adhesive bonding, or the like, and a middle part of the circuit board (32d, 32e) may move relative to a middle part of the holder (38d, 38e). This is not limited in this application.

For example, in the fourth embodiment and/or the fifth embodiment, a coefficient of thermal expansion of a substrate (33d, 33e) may be close to or not close to a coefficient of thermal expansion of the circuit board (32d, 32e).

For example, in the fourth embodiment and/or the fifth embodiment, the substrate (33d, 33e) of the circuit board assembly (3d, 3e) may also adopt a double-layer or a structure of more than two layers. Deformation and match of the substrate (33d, 33e) and an offset effect of the holder (38d, 38e) on the substrate deformation force is used, to maintain deformation of the circuit board (32d, 32e) in a bare board state, and improve a temperature cycle fatigue life of a solder joint (36d, 36e). For a structure of and a specific manner of disposing a multi-layer substrate (33d, 33e), refer to the second embodiment, and details are not described herein again.

For example, in the fourth embodiment and/or the fifth embodiment, the circuit board assembly (3d, 3e) may further include a buffer (not shown in the figure). The buffer may be disposed between the holder (38d, 38e) and the circuit board (32d, 32e) and/or between the circuit board (32d, 32e) and the substrate (33d, 33e). An offset effect of the buffer and the holder (38d, 38e) on a substrate deformation force is used, to maintain deformation of the circuit board (32d, 32e) in a bare board state, and improve a temperature cycle fatigue life of the solder joint (36d, 36e). For a structure of and a specific manner of disposing the buffer, refer to the third embodiment, and details are not described herein again.

For example, in the fourth embodiment and/or the fifth embodiment, the fastener (34d, 34e) may be inserted into the two ends of the holder (38d, 38e). To be specific, an upper surface of the holder (38d, 38e) is in contact with or abutting against a limiting part (341d, 341e) of the fastener (34d, 34e). The buffer may be located between the holder (38d, 38e) and the circuit board (32d, 32e).

For example, refer to FIG. 2A, FIG. 7, and FIG. 9 together. In embodiments of this application, assembly steps of the circuit board assembly 3 are as follows:
S1: Place the first buffer 371 on an upper surface of the substrate 33, and then place the circuit board 32 above the first buffer 371; and/or
place the second buffer 372 above the circuit board 32, where the second buffer 372 may be disposed opposite to the first buffer 371; and/or
place the holder 38d above the circuit board 32 or the second buffer 372.

S2: Insert the fastener into the first buffer 371, the circuit board 32, and/or the holder 38d, and/or the second buffer 372, connect the fastener to the substrate 33 through fastening, and fasten the first buffer 371, the circuit board 32, the substrate 33, and/or the holder 38d, and/or the second buffer 372 together.

For example, the circuit board assembly 3 may not include the first buffer 371. In this case, assembly steps of the circuit board assembly 3 are as follows:
S1: Place the circuit board 32 on an upper surface of the substrate 33, and/or
place the second buffer 372 above the circuit board 32, where the second buffer 372 may be disposed opposite to the first buffer 371; and/or
place the holder 38d above the circuit board 32 or the second buffer 372.

S2: Insert the fastener into the circuit board 32, and/or the holder 38d, and/or the second buffer 372, connect the fastener to the substrate 33 through fastening, and fasten the circuit board 32, the substrate 33, and/or the holder 38d, and/or the second buffer 372 together.

The foregoing descriptions are merely specific implementations of this application, but are not intended to limit the protection range of this application. Any variation or replacement readily figured out by a person skilled in the art within the technical scope disclosed in this application shall fall within the protection range of this application. Embodiments of this application and features in embodiments may be mutually combined provided that no conflict occurs. Therefore, the protection range of this application shall be subject to a protection range of the claims.

## Claims

1. A circuit board assembly, comprising a circuit board and a substrate fastened to a side of the circuit board, wherein the circuit board has a first coefficient of thermal expansion, the substrate has a second coefficient of thermal expansion, and a difference between the second coefficient of thermal expansion and the first coefficient of thermal expansion is less than or equal to 30% of the first coefficient of thermal expansion.

2. The circuit board assembly according to claim 1, wherein the substrate comprises a first backplane and a second backplane, the second backplane is located on a side that is of the first backplane and that is opposite to the circuit board, a coefficient of thermal expansion of the first backplane is less than a coefficient of thermal expansion of the second backplane, and at least one of the first backplane and the second backplane is connected to the circuit board through fastening.

3. The circuit board assembly according to claim 1 or 2, wherein the circuit board assembly further comprises an intermediate buffer, two opposite sides of the intermediate buffer are respectively connected to the circuit board and the substrate through fastening, and the intermediate buffer can generate elastic deformation under an external force.

4. The circuit board assembly according to claim 1 or 2, wherein the circuit board assembly further comprises:
a fastener, wherein the circuit board and the substrate are disposed in a stacked manner and a gap is formed between the circuit board and the substrate, the fastener is disposed at two ends of the circuit board, the fastener is inserted into the circuit board and is connected to the substrate through fastening, and a relative position of the circuit board and the substrate changes when the circuit board assembly is heated;
a first buffer, wherein the first buffer is located on a side that is of the circuit board and that is opposite to the substrate and is in contact with the circuit board, the fastener is inserted into the first buffer, and the first buffer deforms when the circuit board assembly is heated; and/or
a second buffer, wherein the second buffer is located between the circuit board and the substrate and is in contact with the circuit board and the substrate, the fastener is inserted into the second buffer, and the second buffer deforms when the circuit board assembly is heated.

5. The circuit board assembly according to any one of claims 1 to 4, wherein the circuit board assembly further comprises a holder, the holder is located on a side that is of the circuit board and that is opposite to the substrate, two ends of the holder are connected to two ends of the circuit board through fastening, a gap is formed between a middle part of the holder and a middle part of the circuit board, and a coefficient of thermal expansion of the holder is less than a coefficient of thermal expansion of the circuit board.

6. The circuit board assembly according to claim 5, wherein the holder comprises an upper holder and a lower holder that are disposed in a stacked manner and connected through fastening, the upper holder is located on a side that is of the lower holder and that is opposite to the circuit board, two ends of at least one of the upper holder and the lower holder are connected to the circuit board through fastening, a gap is formed between a middle part of the lower holder and a middle part of the circuit board, and a coefficient of thermal expansion of the upper holder is less than a coefficient of thermal expansion of the lower holder.

7. A circuit board assembly, comprising a circuit board and a substrate connected to the circuit board through fastening, wherein the substrate comprises a first backplane and a second backplane, the second backplane is located on a side that is of the first backplane and that is opposite to the circuit board, a coefficient of thermal expansion of the first backplane is less than a coefficient of thermal expansion of the second backplane, and at least one of the first backplane and the second backplane is connected to the circuit board through fastening.

8. The circuit board assembly according to claim 7, wherein the circuit board assembly further comprises an intermediate buffer, two opposite sides of the intermediate buffer are respectively connected to the circuit board and the substrate through fastening, and the intermediate buffer can generate elastic deformation under an external force.

9. The circuit board assembly according to claim 8, wherein the circuit board assembly further comprises:
a fastener, wherein the circuit board and the substrate are disposed in a stacked manner and a gap is formed between the circuit board and the substrate, the fastener is disposed at two ends of the circuit board, is inserted into the circuit board and is connected to the substrate through fastening, and a relative position of the circuit board and the substrate changes when the circuit board assembly is heated;
a first buffer, wherein the first buffer is located on a side that is of the circuit board and that is opposite to the substrate and is in contact with the circuit board, the fastener is inserted into the first buffer, and the first buffer deforms when the circuit board assembly is heated; and/or
a second buffer, wherein the second buffer is located between the circuit board and the substrate and is in contact with the circuit board and the substrate, the fastener is inserted into the second buffer, and the second buffer deforms when the circuit board assembly is heated.

10. The circuit board assembly according to any one of claims 7 to 9, wherein the circuit board assembly further comprises a holder, the holder is located on a side that is of the circuit board and that is opposite to the substrate, two ends of the holder are connected to two ends of the circuit board through fastening, a gap is formed between a middle part of the holder and a middle part of the circuit board, and a coefficient of thermal expansion of the holder is less than a coefficient of thermal expansion of the circuit board.

11. The circuit board assembly according to claim 10, wherein the holder comprises an upper holder and a lower holder that are disposed in a stacked manner and connected through fastening, the upper holder is located on a side that is of the lower holder and that is opposite to the circuit board, two ends of at least one of the upper holder and the lower holder are connected to the circuit board through fastening, a gap is formed between a middle part of the lower holder and a middle part of the circuit board, and a coefficient of thermal expansion of the upper holder is less than a coefficient of thermal expansion of the lower holder.

12. A circuit board assembly, comprising a circuit board, a substrate, and a fastener, wherein the circuit board and the substrate are disposed in a stacked manner and a gap is formed between the circuit board and the substrate, the fastener is disposed at two ends of the circuit board, the fastener is inserted into the circuit board and is connected to the substrate through fastening, and a relative position of the circuit board and the substrate changes when the circuit board assembly is heated;
the circuit board assembly further comprises:
a first buffer, wherein the first buffer is located on a side that is of the circuit board and that is opposite to the substrate and is in contact with the circuit board, the fastener is inserted into the first buffer, and the first buffer deforms when the circuit board assembly is heated; and/or
a second buffer, wherein the second buffer is located between the circuit board and the substrate and is in contact with the circuit board and the substrate, the fastener is inserted into the second buffer, and the second buffer deforms when the circuit board assembly is heated.

13. The circuit board assembly according to claim 12, wherein the first buffer adopts foam, rubber, or a spring, and/or the second buffer adopts foam, rubber, PTFE, or a spring.

14. The circuit board assembly according to claim 12 or 13, wherein the fastener comprises a limiting part and a plug connector that are connected through fastening, the limiting part protrudes outwards relative to a peripheral side of the plug connector, and the first buffer is located between the limiting part and the circuit board and is in contact with the limiting part and the circuit board.

15. The circuit board assembly according to any one of claims 12 to 14, wherein the circuit board assembly further comprises a holder, the holder is located on a side that is of the circuit board and that is opposite to the substrate, two ends of the holder are connected to two ends of the circuit board through fastening, a gap is formed between a middle part of the holder and a middle part of the circuit board, and a coefficient of thermal expansion of the holder is less than a coefficient of thermal expansion of the circuit board.

16. The circuit board assembly according to claim 15, wherein the holder comprises an upper holder and a lower holder that are disposed in a stacked manner and connected through fastening, the upper holder is located on a side that is of the lower holder and that is opposite to the circuit board, two ends of at least one of the upper holder and the lower holder are connected to the circuit board through fastening, a gap is formed between a middle part of the lower holder and a middle part of the circuit board, and a coefficient of thermal expansion of the upper holder is less than a coefficient of thermal expansion of the lower holder.

17. A circuit board assembly, comprising a circuit board, a substrate, and a holder, wherein the substrate is connected to the circuit board through fastening, the holder is located on a side that is of the circuit board and that is opposite to the substrate, two ends of the holder are connected to two ends of the circuit board through fastening, a gap is formed between a middle part of the holder and a middle part of the circuit board, and a coefficient of thermal expansion of the holder is less than a coefficient of thermal expansion of the circuit board.

18. The circuit board assembly according to claim 17, wherein the holder comprises an upper holder and a lower holder that are disposed in a stacked manner and connected through fastening, the upper holder is located on a side that is of the lower holder and that is opposite to the circuit board, two ends of at least one of the upper holder and the lower holder are connected to the circuit board through fastening, a gap is formed between a middle part of the lower holder and a middle part of the circuit board, and a coefficient of thermal expansion of the upper holder is less than a coefficient of thermal expansion of the lower holder.

19. An electronic device, comprising the circuit board assembly according to any one of claims 1 to 18, wherein the circuit board assembly comprises a chip, and the chip is fastened to a side that is of the circuit board and that is opposite to the substrate.
